# EUROPEAN PATENT APPLICATION

(11) **EP 1 596 253 A1**
(43) Date of publication of application: **16.11.2005**
(21) Application number: 04711697.5
(22) Date of filing: 17.02.2004
(51) Int. Cl.: G03F 7/40, G03F 7/00, G03F 7/032

(54) **PROCESS FOR PRODUCING WATER DEVELOPMENT PRINTING PLATE FOR RELIEF PRINTING**

(30) Priority: 19.02.2003 JP 2003041650
(71) Applicant: Asahi Kasei Chemicals Corporation, Tokyo 100-8440 (JP)
(72) Inventor: HARAGUCHI, Keiichi,2Asahikaseinishiapato 826, Shizuoka 416-0939 (JP); YOSHIDA, Masahiro, Fuji-shi, Shizuoka 416-0909 (JP)
(74) Representative: von Kreisler, Alek
(86) International application number: PCT/JP2004/001681
(87) International publication number: WO 2004/074942

(57) **Abstract**

A process for producing a water-developable printing plate for use in relief printing, comprising subjecting a solid plate made of a photosensitive resin composition including at least (a) a hydrophilic resin, (b) a hydrophobic resin, (c) a photopolymerizable unsaturated compound and (d) a photopolymerization initiator to at least an exposure step with actinic light, a development step and a post-exposure step, wherein the above described post-exposure step is carried out in a low oxygen concentration environment.

## Description

### TECHNICAL FIELD

The present invention relates to a process for producing a printing plate having a long plate life from a water-developable photosensitive resin solid plate for use in relief printing.

### BACKGROUND ART

Resin printing plates made of water-developable solid plates for use in relief printing are usually produced by kneading a hydrophilic resin, a hydrophobic resin, a photopolymerizable unsaturated compound and a photosensitizer, and by sandwiching the kneaded product thus obtained between two sheets of polyethylene film to form a plate, as described in JP-A-3-136052, JP-A-10-31303, U.S. Patent No. 5,348,844 or U.S. Patent No. 4,806,506. A printing plate is generally produced by subjecting this plate to image exposure through a negative film, removing the unexposed portion thereof by washing with an aqueous developer, and then subjecting the washed plate to a post-treatment (post-exposure).

In a water-developable solid plate, a hydrophilic resin and a hydrophobic resin are frequently used in combination for the purpose of simultaneously satisfying contradicting properties, namely, the water developability and the ink resistance. Because the water-developable solid plate thus includes a hydrophilic resin easily compatible with the ink components, and an interface is to be found between the hydrophilic resin and the hydrophobic resin because of the mutual incompatibility in molecular level of these resins, the durability (the plate life) in long-term printing and ink blotting in the halftone dot portion of the printing plate have hitherto posed significant problems, generally, in contrast to the so-called solvent-developable printing plate in which only a hydrophobic resin is included and development is carried out only with an organic solvent.

For the purpose of solving these problems, various plate making processes have been proposed.

JP-A-2001-290286 discloses a process developed by the present inventors in which by conducting a post-exposure with actinic light by use of a hydrogen-abstracting photosensitizer, the plate surface is detackified and simultaneously the water-developable photosensitive resin solid plate is reinforced. In this process, because the hydrogen-abstracting agent added onto the plate surface is made to diffuse while the plate is being dried, there is posed a problem such that the durability is extremely degraded if the exposure quantity of the short wavelength ultraviolet light is not appropriately controlled according to the drying time, the drying temperature and the thickness of the printing plate. Also, in the process described in the aforementioned publication, the ink blotting in the halftone dot portion of the printing plate can not be prevented.

On the other hand, for the purpose of detackifying the plate surface after development, namely, for the purpose different from that in the present invention, it is known that the post-exposure is carried out in water. For example, European Patent No. 17927 (JP-A-55-135838) proposes a process in which, subsequently to the development step and the drying step, the surface of a plate is irradiated with light of wavelengths of 300 nm or less while the plate is being immersed in water. However, the aforementioned publication involves only a resin plate made of a hydrophobic resin or a hydrophilic resin, and no description can be found therein on the mixed resin system composed of a hydrophilic resin and a hydrophobic resin according to the present invention and also on the problems inherent to the mixed resin system. Also in the aforementioned publication, no description is made on the difference between the post-exposure effect in the atmosphere (in an atmosphere of oxygen) and that in water (in a low oxygen atmosphere).

Furthermore, JP-A-50-2070 also proposes a process for producing a liquid photosensitive resin composed of a hydrophilic resin in which process after the development step, the plate surface is irradiated with actinic light while the plate is being immersed in water, for the purpose of detackifying the printing plate surface. However, also herein, no description can be found on the mixed resin system composed of a hydrophilic resin and a hydrophobic resin according to the present invention and also on the problems inherent to the mixed resin system.

### DISCLOSURE OF THE INVENTION

The present invention has been achieved by focusing attention on the above problems of such conventional techniques. Accordingly, the present invention takes as its problem to provide a plate making process capable of producing a printing plate which is produced from a water-developable photosensitive resin solid plate composed of a combination of a hydrophilic resin and a hydrophobic resin, and nevertheless has a long plate life, and in which ink blotting in the halftone dot portion of the plate surface scarcely occurs (ink fill-in in the halftone portion scarcely occurs).

For the purpose of solving the aforementioned problems, the present inventors have perfected the present invention by focusing attention on the implementation of the post-exposure in a low oxygen concentration atmosphere. More specifically, the present invention will be described as follows.
(1) A process for producing a water-developable printing plate for use in relief printing, comprising subjecting a solid plate made of a photosensitive resin composition including at least (a) a hydrophilic resin, (b) a hydrophobic resin, (c) a photopolymerizable unsaturated compound and (d) a photopolymerization initiator to at least an exposure step with actinic light, a development step and a post-exposure step, wherein the above described post-exposure step is carried out in a low oxygen concentration environment.
(2) The process according to aforementioned (1), wherein in the above described post-exposure step, exposure is carried out with ultraviolet light of at least 200 nm to 300 nm wavelength.
(3) The process according to aforementioned (1), wherein the above described low oxygen concentration environment is water.
(4) The process according to aforementioned (1), wherein the above described low oxygen concentration environment is an atmosphere under reduced pressure or an inert gas atmosphere through a film having a transmittance of 5% or more for 250 nm ultraviolet light.
(5) The process according to aforementioned (1), wherein the above described low oxygen concentration environment is an atmosphere under reduced pressure or an inert gas atmosphere.
(6) The process according to any one of aforementioned (1) to (5), wherein the above described hydrophilic resin comprises a conjugated diene as a main component, comprises at least one hydrophilic group selected from the group consisting of a carboxylic acid group, a hydroxy group, a phosphoric acid group and a sulfonic acid group, and has a saturated water content of 1% or more.
(7) The process according to any one of aforementioned (1) to (5), wherein the above described hydrophilic resin comprises fine particles of 5 µm or less in particle diameter with a gel-insoluble fraction of 60% by mass or more, and has a saturated water content of 1% or more.
(8) A photosensitive resin printing plate for use in relief printing produced by a process according to any one of aforementioned (1) to (7).

### BEST MODE FOR CARRYING OUT THE INVENTION

The present invention will be described below in detail, particularly with a focus on the preferred embodiments.

First, the present plate making process is applied to the below described production of a water-developable printing plate.

More specifically, the water-developable solid plate according to the present invention is a sheet-shaped water-developable solid plate including (a) a hydrophilic resin, (b) a hydrophobic resin, (c) a photopolymerizable unsaturated compound and (d) a photopolymerization initiator, and preferably having a 0.5 mm to 10 mm thick photosensitive resin composition layer.

The hydrophilic resin (a) in the present invention means a resin including a polymer having in the molecule thereof hydrophilic groups such as a sulfonic acid group, a phosphoric acid group and a carboxylic acid group, and having a water content of 1% or more under the condition that the resin has been maintained at a temperature of 40°C and at a humidity of 80% for 7 days; and examples of the aforementioned hydrophilic resin may include a radical copolymer, a polyamide polymer, a polyvinylalcohol polymer, a polyester polymer or a urethane copolymer.

Hydrophilic resins used in water-developable solid plates such as "Cosmolight" (trade name) available from Toyobo Co., Ltd., "AQS" (trade name) available from Du Pont Corp. and "Flexceed" (trade name) available from Nippon Paint Co., Ltd. may also be used as the hydrophilic resin in the present invention.

Examples of the hydrophilic radical copolymer may include a copolymer obtained from a copolymerization using 1.0 part by mass or more of a hydrophilic unsaturated monomer of the total amount of the unsaturated monomers. The used amount of such an aforementioned hydrophilic unsaturated monomer having an acidic functional group may preferably be 1 to 30 parts by mass of the total amount of the unsaturated monomers. When the used amount is 1 part by mass or more, a water-based development may be satisfactorily applied, while when the used amount is 30 parts by mass or less, the moisture absorption amount of the photosensitive resin and the swelling magnitude of the ink are not increased, and the workability of the photosensitive resin at the time of mixing can be maintained.

Examples of the hydrophobic unsaturated monomer usable for the hydrophilic radical copolymer may include a conjugated diene, an aromatic vinyl compound, (meth)acrylate, ethylenic monocarboxylic acid alkyl ester monomers having a hydroxy group, unsaturated dibasic acid alkyl esters, maleic anhydride, vinyl cyanide compounds, (meth)acrylamide and the derivatives thereof, vinyl esters, vinyl ethers, vinyl halides, basic monomers having an amino group, vinyl pyridine, olefin, silicon-containing α,β-ethylenically unsaturated monomers and allyl compounds. These monomers may be used each alone or as mixtures of two or more thereof.

Monomers having two or more addition-polymerizable groups may also be used.

The content of the hydrophilic resin is preferably set in a range from 10 parts by mass to 80 parts by mass in relation to 100 parts by mass of the photosensitive resin composition. The types of the hydrophilic groups may be appropriately selected from the viewpoints of the developability, the water resistance and the thermal stability. Resins containing carboxylic acid groups are preferable because such resins are industrially easily available, attain water developability with a small content thereof and are satisfactory in water resistance. Resins containing a conjugated diene resin as the main component are more preferable because such resins are flexible and tough. Fine particle materials each having a particle diameter of 5 µm or less and a gel-insoluble fraction of 60% by mass or more are preferable because such particle materials exhibit water developability with a small content thereof and are industrially easily available.

The hydrophobic resin (b) in the present invention is preferably a resin which has a water content of 0.5% or less under the conditions that the resin has been maintained at a temperature of 40°C and at a humidity of 80% for 7 days, and is also a resin which is soft, elastic and tough for printing. Polymers made of butadiene or isoprene as the main component are preferable because such polymers have double bonds in the molecules thereof and capable of causing crosslinking reaction by a photopolymerization initiator under photoirradiation to increase the plate life as the printing plate. The content of the hydrophobic resin (b) is preferably set in a range from 5 parts by mass to 80 parts by mass in relation to 100 parts by mass of the photosensitive resin composition. Specific examples of the hydrophobic resin may include styrene/butadiene polymer, α-methylstyrene/butadiene polymer, p-methylstyrene/butadiene polymer and p-methoxystyrene/butadiene polymer, and any polymerized state such as a block polymer or random polymer may be adopted. Styrene/butadiene block copolymer or styrene/isoprene block copolymer is preferably used because of easy availability.

As for the photopolymerizable unsaturated compound (c) in the present invention, any compound may be used as long as it has one or more unsaturated double bonds in the molecule and is liquid or solid at the temperature at which it is used.

The content of the photopolymerizable unsaturated compound (c) is preferably set in a range from 0.5 part by mass to 30 parts by mass in relation to 100 parts by mass of the composition.

As the photopolymerizable unsaturated compound (c), acrylic acid compounds and methacrylic acid compounds are preferably used because these compounds are highly reactive and highly compatible with various compounds, and the esters of these aforementioned compounds are more preferably used on the grounds that these esters are low in toxicity and metal corrodibility. Specific examples of such esters may include alkyl (meth)acrylate, cycloalkyl (meth)acrylate, haloalkyl (meth)acrylate, alkoxyalkyl (meth)acrylate, hydroxyalkyl (meth)acrylate, aminoalkyl (meth)acrylate, tetrahydrofurfuryl (meth)acrylate, allyl (meth)acrylate, glycidyl (meth)acrylate, benzyl (meth)acrylate, phenoxy (meth)acrylate, alkylene glycol (meth)acrylate, polyoxyalkylene glycol (meth)acrylate and alkylpolyol poly(meth)acrylate. More specific examples may include ethylene glycol (meth)acrylate, tetraethylene glycol (meth)acrylate, hexamethylene (meth)acrylate, nonamethylene (meth)acrylate, methylolpropane (meth)acrylate, glycerin (meth)acrylate, pentaerythrite (meth)acrylate, phenoxyethyl (meth)acrylate, phenoxytetraethylene glycol (meth)acrylate and ethoxylated bisphenol-A (meth)acrylate.

A low-molecular weight polybutadiene, a modified polybutadiene and the like can also be used as a photopolymerizable unsaturated compound and simultaneously as a plasticizer. Specific examples concerned may include a liquid polybutadiene having a molecular weight of 500 to 5000, a maleination modified polybutadiene and an acrylate-modified polybutadiene.

A maleimide compound can also be used as a photopolymerizable unsaturated compound. Specific examples of such a compound may include lauryl maleimide and cyclohexyl maleimide.

A multifunctional unsaturated compound is also used as a photopolymerizable unsaturated compound. The compound means a compound in which the number of the unsaturated double bonds therein is two or more. When such a compound is included, the content thereof is preferably set in a range from 0.05 part by mass to 10 parts by mass in relation to 100 parts by mass of the composition. Examples of such a multifunctional unsaturated compound may include alkyl di(meth)acrylate, cycloalkyl di(meth)acrylate, haloalkyl di(meth)acrylate, alkoxyalkyl di(meth)acrylate, hydroxyalkyl di(meth)acrylate, aminoalkyl di(meth)acrylate, tetrahydrofurfuryl di(meth)acrylate, allyl di(meth)acrylate, glycidyl di(meth)acrylate, benzyl di(meth)acrylate, phenoxy di(meth)acrylate, alkylene glycol di(meth)acrylate, polyoxyalkylene glycol di(meth)acrylate and alkylpolyol di(meth)acrylate. More specific examples of such a compound may include diethylene glycol di(meth)acrylate, tetraethylene glycol di(meth)acrylate, hexamethylene di(meth)acrylate, nonamethylene di(meth)acrylate, trimethylolpropane tri(meth)acrylate, tricyclodecane di(meth)acrylate, glycerin tri(meth)acrylate, pentaerythrite tetra(meth)acrylate, phenoxyethyl di(meth)acrylate, phenoxytetraethylene glycol di(meth)acrylate and ethoxylated bisphenol-A di(meth)acrylate. These multifunctional unsaturated compounds are usually used in combination with the above described unsaturated compounds for the purpose of controlling the hardness and the resolution of printing plates in such a way that these multifunctional unsaturated compounds are made to be contained in advance in the composition.

The photopolymerization initiator (d) in the present invention means a compound which absorbs light energy to generate a radical, for which various photopolymerization initiators well known in the art can be used. Various organic carbonyl compounds, in particular, aromatic carbonyl compounds are preferable. Examples of such compounds may include: benzophenone, 4,4-bis(diethylamino)benzophenone, t-butylanthraquinone and 2-ethylanthraquinone; thioxanthones such as 2,4-diethylthioxanthone, isopropylthioxanthone and 2,4-dichlorothioxanthone; acetophenones such as diethoxyacetophenone, 2-hydroxy-2-methyl-1-phenylpropan-1-one, benzyldimethylketal, 1-hydroxycyclohexylphenyl ketone, 2-methyl-2-morpholino(4-thiomethylphenyl)propan-1-one and 2-benzyl-2-dimethylamino-1-(4-morpholinophenyl)butane; benzoin ethers such as benzoin methyl ether, benzoin ethyl ether, benzoin isopropyl ether and benzoin isobutyl ether; acylphosphine oxides such as 2,4,6-trimethylbenzoyldiphenylphosphine oxide, bis(2,6-dimethoxybenzoyl)-2,4,4-trimethylpentylphosphine oxide, and bis(2,4,6-trimethylbenzoyl)-phenylphosphine oxide; methylbenzoyl formate; 1,7-bisacridinylheptane; and 9-phenylacridine. These compounds may be used each alone or in combinations of two or more thereof.

The content of the photopolymerization initiator (d) is preferably set to be from 0.1 to 10 parts by mass in relation to 100 parts by mass of the photosensitive resin composition. The content of 0.1 part by mass or more is preferable from the viewpoint of the formability of small points and characters, and the content of 10 parts by mass or less is preferable from the viewpoint of the prevention of the exposure sensitivity degradation caused by the transmittance decrease for actinic light such as ultraviolet light.

The photosensitive resin composition according to the present invention is prepared by mixing the aforementioned respective ingredients by means of a method well known in the art to be formed into a sheet-shaped article. The thickness of the photosensitive resin composition layer in the water-developable solid plate is 0.5 mm to 10 mm. When the above described layer is too thin, the rubber elastic force thereof becomes small to degrade the followability thereof to soft surface, so that such a too thin layer is not generally applied to the relief printing plate. Furthermore, when the thickness of the above described layer is 10 mm or more, the printing performance thereof stays unchanged, but there occurs a drawback that the printing plate becomes intractable owing to the weight thereof. The photosensitive resin layer is generally manufactured and stored as sandwiched by a supporting film, an adhesive layer according to need, and a cover film, and is used in the exposure step with the cover film removed at the time of the plate making operation. In general, the photosensitive resin is highly adhesive in an unexposed condition, and hence an adhesion preventing layer, containing as the main components a water soluble resin such as PVA and a water dispersible resin, is provided outside the photosensitive resin layer for the purpose of preventing the adhesion to the cover film and the negative film.

The photosensitive resin layer is subjected to the plate making at least by passing through the exposure step with actinic light, the development step and the post-exposure step.

The exposure step as referred to in the present invention means a step in which actinic light irradiation is selectively carried out through a negative film prepared or a layer subjected to abrasion with infrared laser or the like so as to permit light irradiation onto the positions where the raised portions are to be formed, to photocure the irradiated portions.

The portions not irradiated with actinic light are removed in the subsequent development step.

As the actinic light source used in the present invention, preferable are a low pressure mercury lamp, a high pressure mercury lamp, an ultraviolet fluorescent lamp, a carbon arc lamp, a xenon lamp, a zirconium lamp, sunlight and the like.

The development step as referred to in the present invention means a step in which the portions unexposed in the exposure step are selectively removed by chemical means such as a developer or physical means such as brushing or washing with high pressure water.

As a liquid developer, water or a water based liquid developer containing water and a surfactant is used. As the surfactant, a nonionic surfactant, an anionic surfactant, a cationic surfactant and an amphoteric surfactant are used each alone or as mixtures of two or more thereof.

Specific examples of the preferable anionic surfactant may include a linear alkylbenzene sulfonate having an alkyl group having with an average carbon number of 8 to 16, an α-olefin sulfonate with an average carbon number of 10 to 20, a dialkyl sulfosuccinate having an alkyl or an alkenyl group with a carbon number of 4 to 10, a fatty acid lower alkyl ester sulfonate, an alkyl sulfate with an average carbon number of 10 to 20, an alkyl ether sulfate having a linear or branched alkyl or alkenyl group with an average carbon number of 10 to 20 and added with 0.5 to 8 mol, on average, of ethylene oxide, and a saturated or unsaturated fatty acid salt with an average carbon number of 10 to 22.

Specific examples of the preferable cationic surfactant may include an alkyl amine salt, an alkyl amine ethylene oxide adduct, an alkyl trimethyl ammonium salt, an alkyl dimethyl benzyl ammonium salt, a Sapamine-type quaternary ammonium salt and a pyridium salt.

Specific examples of the preferable nonionic surfactant may include a polyethylene glycol-type higher alcohol alkylene oxide adduct, an alkylphenol alkylene oxide adduct, a fatty acid alkylene oxide adduct, a polyhydric alcohol fatty acid ester alkylene oxide adduct, a higher alkyl amine alkylene oxide adduct, a fatty acid amide alkylene oxide adduct, an alkylene oxide adduct of a fat and oil, a polypropylene glycol alkylene oxide adduct, a polyhydric glycerol fatty acid ester, a pentaerythritol fatty acid ester, a sorbitol fatty acid ester, a sorbitan fatty acid ester, a sucrose fatty acid ester, a polyhydric alcohol alkyl ether, and fatty acid amides of alkanol amines.

Specific examples of the preferred amphoteric surfactant may include sodium laurylaminopropionate and lauryldimethyl betaine.

No particular constraint is imposed on the concentration of a surfactant, but the surfactant concentration usually preferably is in a range from 0.5 to 10 wt%.

According to need, the surfactant can be blended with developing aids such as a development accelerator and a pH adjustor.

Examples of the development accelerator may include amines such as monoethanolamine, diethanolamine and triethanolamine; glycol ethers; ammonium salts such as tetramethylammonium hydroxide; and paraffin hydrocarbons.

Examples of the pH adjustor may include sodium borate, sodium carbonate, sodium silicate, sodium metasilicate, sodium succinate and sodium acetate.

The developing aids are used each alone or as mixtures of two or more thereof.

The boiling point of the developing aid to be used is preferably 130°C or above under normal pressure. In the case where the boiling point is lower than this temperature, a considerable amount of the solvent tends to be distilled off together with water when the liquid developer is recovered as a condensate by evaporating water from the liquid developer, or it takes a lot of trouble to inevitably measure and adjust the content of the solvent, present concomitantly with water for the purpose of stabilizing the performance of the liquid developer when the distilling-off of water is applied for the purpose of adjusting the concentration of the liquid developer.

According to need, a defoaming agent, a dispersant, a corrosion inhibitor and an antiseptic agent may also be used additionally.

The post-exposure step of the present invention is a step in which, the plate surface is exposed after the development step, in a low oxygen concentration atmosphere. Herewith, the plate life can be improved and the ink fill-in can be suppressed.

In the post-exposure step for a conventional photosensitive solid plate, the irradiation treatment with actinic light has been carried out in the atmosphere. After the development step, the plate still has tackiness on the surface thereof because the polymerization reaction is not necessarily fully completed, and accordingly unreacted monomers and oligomers remain in the plate. Therefore, the tackiness is generally reduced by irradiation of an appropriate quantity of ultraviolet light around 254 nm in the atmosphere so that neither dust nor litter may stick while the plate is being stored or applied to printing.

Preferably, the plate is irradiated with light of 200 nm to 300 nm wavelength. When the wavelength is 200 nm or more, harmful ozone which has an intense odor and is highly reactive is hardly generated, while when the wavelength is 300 nm or less, the tackiness of the plate surface can be removed and the plate life can be improved. Thus, the irradiation of light in the above described range makes it possible to improve the plate life and suppress the ink fill-in, and additionally to remove the tackiness of the plate surface.

Examples of the exposure lamp may include mercury lamps exhibiting the maximum energy intensity at 254 nm such as TUV (trade name, manufactured by pHILIPS) and GL (trade name, manufactured by Sankyo Denki K.K.).

In the post-exposure step, in addition to the irradiation of light of 200 nm to 300 nm wavelength, light exhibiting a maximum energy intensity in a range from 300 nm to 400 nm may be irradiated simultaneously or separately.

After the development step, the liquid developer adhering onto the plate may be simply washed out with water or the like and the plate as it is may be subjected to the post-exposure treatment, but it is preferable that the plate is dried in a oven at about 60°C for 5 minutes to 120 minutes, and then subjected to the post-exposure treatment because in this way the back surface of the plate does not become opaque.

Now, the low oxygen concentration atmosphere in the present invention will be described below separately on the atmosphere in a gas and the atmosphere in a liquid.

The partial pressure of oxygen in the atmosphere is usually 20 kPa, but the low oxygen concentration atmosphere in the present invention means an atmosphere in which the partial pressure of oxygen is 7 kPa or less, preferably 5 kPa or less, and most preferably 1 kPa or less. When described in terms of the oxygen molar concentration, the oxygen molar concentration in the atmosphere is about 8.7 mol/m³, but the low oxygen concentration atmosphere concerned means an atmosphere in which the oxygen molar concentration is 3 mol/m³ or less, preferably 2 mol/m³ or less, and most preferably 0.5 mol/m³ or less. When the oxygen molar concentration is larger than 3 mol/m³, the amount of the generated ozone is increased and side reactions tend to occur to an increased extent.

Next, the atmosphere in a liquid will be described below. Although the partial pressure of oxygen in water keeps equilibrium with the partial pressure of oxygen in the atmosphere, the oxygen concentration in water is low because water molecules are present, and hence a low oxygen concentration atmosphere is attained. Specifically, at 20°C and at an atmospheric pressure of 1 atm, the equilibrium oxygen concentration in water is about 9 ppm, and the corresponding molar concentration is 0.28 mol/m³. A treatment in water is industrially easy, and excellent in safety of handling, so that it is preferable to set the low oxygen concentration atmosphere in water.

When the plate gets with water, the drying treatment becomes necessary. Thus, when it is necessary to carry our the plate making rapidly by reducing the treatment time, it is preferable that, in place of the environment in water, a low oxygen concentration atmosphere is created by adhering onto the plate a film having a transmittance of 5% or more for short wavelength ultraviolet light and extracting the air, or a closed space is formed by means of a general method and the oxygen concentration therein is made to be equal to or lower than the above described concentration by making the interior of the space be in a reduced pressure condition or by filling the space with an inert gas (in general, economically favorable nitrogen gas or carbon dioxide gas).

As for the film having a transmittance of 5% or more for short wavelength ultraviolet light, no problem is posed if the film is formed of any polymer as long as the film can substantially transmit ultraviolet light of a wavelength as short as 250 nm at a transmittance of 5% or more. Specific examples of such a film may include films made of olefin polymer such as polyethylene film and polypropylene film; films made of fluorinated polymers; films made of silicon polymers; and films made of chlorinated polymers.
Among these, polyethylene film is preferable because it is flexible and easily available. Further, it is preferable that the transmittance for short wavelength ultraviolet light is as large as possible because the post-exposure treatment time can thereby be made short, the transmittance being preferably 5% or more, and more preferably 30% or more.

Now, the present invention will be described more specifically with reference to Referential Example, Examples and Comparative Examples, but the present invention is not limited these Examples. Referential Example

### (1) Synthesis of the hydrophilic resin (a)

A pressure reaction vessel equipped with a stirrer and a temperature control jacket was charged with 125 parts by mass of water and 3 parts by mass of an emulsifying agent (the ammonium salt of α-sulfo-(1-(nonylphenoxy)methyl-2-(2-propenyloxy)ethoxy-poly(oxy-1,2-ethanediyl); trade name: ADEKA REASOAP SE-1025, manufactured by Asahi Denka Co., Ltd.) initially charged, and the internal temperature was elevated up to 80°C; an oily mixture composed of 10 parts by mass of styrene, 70 parts by mass of butadiene, 13 parts by mass of 2-ethylhexyl acrylate, 5 parts by mass of methacrylic acid, 2 parts by mass of acrylic acid and 2 parts by mass of t-dodecylmercaptane, and an aqueous solution composed of 28 parts by mass of water, 1.2 parts by mass of sodium peroxodisulfate, 0.2 part by mass of sodium hydroxide and 1 part by mass of an emulsifying agent (trade name: ADEKA REASOAP SE-1025, manufactured by Asahi Denka Co., Ltd.) were added thereto over a period of 5 hours and a period of 6 hours, respectively, each at a constant flow rate. The reaction liquid thus obtained was maintained at the same temperature as above for 1 hour to complete the polymerization reaction, and subsequently the reaction liquid was cooled. Then, the produced copolymer latex was adjusted to pH 7 with sodium hydroxide, thereafter the unreacted monomers were removed by steam stripping, filtration was carried out with a piece of 200 mesh metal gauze, and an adjustment was made so as for the solid content concentration to finally be 40 wt% to yield a hydrophilic copolymer solution. The number average particle diameter of the hydrophilic copolymer was 40 nm. The particle diameter was obtained as the number average particle diameter by means of a particle size analyzer available from Nikkiso Co., Ltd. under the trade name MICROTRAC (model: 9230UPA).

The emulsion-polymerized solution was dried at 60°C to yield a hydrophilic copolymer. The saturated water content of the hydrophilic copolymer was found to be 3% when it had been allowed to stand in an atmosphere of a temperature of 40°C and a humidity of 100% for 7 days.

### (2) Preparation of a photosensitive resin composition and a photosensitive resin plate

By use of a pressure kneader, 30 parts by mass of the hydrophilic resin (a) obtained in (1) and 25 parts by mass of a styrene/butadiene block copolymer (Clayton D-KX405 (trade name), manufactured by Sell Chemical Corp.) (saturated water content: 0.1%) as the hydrophobic resin (b) were mixed at 140°C for 10 minutes; thereafter, 8 parts by mass of 1,6-hexanediol dimethacrylate and 4 parts by mass of 1,6-hexanediol diacrylate as the photopolymerizable unsaturated compounds (c), 2.5 parts by mass of 2,2-dimethoxyphenylacetophenone as the photopolymerization initiator (e), 30 parts by mass of a liquid polybutadiene (manufactured by Nihon Petrochemical Co., Ltd.: trade name: B2000) as a plasticizer, and 1.5 parts by mass of 2,6-di-t-butyl-p-cresol as an antioxidant were added by bits over a period of 15 minutes, and on completion of the addition, the reaction mixture thus obtained was further kneaded for 10 minutes to yield a photosensitive resin composition.

The composition was taken out and sandwiched between a 100 µm thick polyester film (hereinafter abbreviated as PET) with the one side thereof coated with an adhesive using a thermoplastic elastomer and a 100 µm thick PET with the one side thereof coated with polyvinyl alcohol (PVA) as a 5 µm thick layer, and then molded at 130°C by use of a pressing machine into a 3 mm thick plate.

### (3) Preparation of a printing plate

The molded plate, made of the photosensitive resin composition, obtained in (2) was exposed from the side of the PET coated with an adhesive by use of a lamp exposure apparatus (trade name: JE-A2-SS, manufactured by Nihon Denshi Seiki Co., Ltd.), exhibiting a maximum energy intensity at 370 nm, so as for the cured layer to have a thickness of about 2 mm.

Then, the PET coated with PVA was peeled off so as to leave the PVA on the resin surface, a negative film of a printing image was adhered onto the peeled surface, and then the molded plate of the aforementioned composition was exposed for 10 minutes with the above described exposure apparatus. After the exposure, the negative film was peeled off, and the unexposed portions thereof were removed by washing at 50°C with a brushing washer manufactured by Nihon Denshi Seiki Co., Ltd. (trade name: JOW-A3-P) by using a prepared aqueous solution (a water-based liquid developer) composed of 4 wt% of an alkylene oxide adduct of a higher alcohol, 0.4 wt% of diethylene glycol dibutyl ether, 0.5 wt% of diethylene glycol monohexyl ether and 0.4 wt% of sodium carbonate. Then, the liquid developer on the plate surface was simply washed off with tap water and dried at 60°C for 30 minutes. Subsequently, by use of a light source in which ultraviolet germicidal lamps exhibiting a maximum energy intensity at 254 nm (trade name: GL30, 30 W, manufactured by Toshiba Corp., hereinafter abbreviated as UVC) and ultraviolet chemical lamps exhibiting a maximum energy intensity at 370 nm (trade name: FLR20S, 20 W, manufactured by Toshiba Corp., hereinafter abbreviated as UVA) were alternately arranged, a simultaneous exposure was carried out to prepare a printing plate.

By use of a UV actinometer UV-MO2 (trade name, manufactured by ORC Co., Ltd.), the exposure light intensities were measured with a UV-25 sensor for UVC and with a UV-37 sensor for UVA.

### (4) Evaluation methods

### (a) Removability of the tackiness of the printing plate surface

PET was pressed against the plate surface and sensory evaluation was made as to whether or not PET is easily peeled off.

### (b) Plate life (number of printed sheets) evaluation

By use of the plates obtained in Referential Example, Examples and Comparative Examples, printing was carried out with a printing machine manufactured by Newlong Machine Works, Ltd. Each of the plates was wound around the cylinder and evaluation was made as to how many sheets of paper were able to be printed by use of a water-based ink. As the number of printed sheets is increased, streak-like wear traces are formed in the solid portions, and when these traces become deeper than the surrounding area to reach depths of about 20 µm, outline character printing can hardly be carried out even by controlling the pressure of the printing press roll. Accordingly, such a time point was judged as the termination time of the printing.

### (c) Ink fill-in property in the halftone portion of the printing plate

In the printing of (b), on completion of printing of 1000 sheets, when no ink fill-in was found by visual inspection in the 3%, 5% and 10% halftone portions, according to the 133-line printing mode, of the printed paper sheet, the plate concerned was judged as "good" and represented by "yes". When even the slightest ink fill-in was found, the plate concerned was judged as "problematic" and represented by "no". Example 1

Brushing development treatment was carried out according to the method of Referential Example, and the plate was dried at 60°C for 30 minutes, when the plate surface was tacky as felt by touching; a clean PET film was pressed against the surface and then the film was tried to peel off again but was hardly peeled off, and when forcibly peeled off, some scratches were left on the surface.

Next, the plate was immersed in water at the depth of 2 cm, and under this condition, the plate was exposed to UVA in a light quantity of 1000 mJ and to UVC in a light quantity of 2000 mJ. After the exposure treatment, the plate was free from tackiness in such a way that a PET film pressed against the plate surface was able to be easily peeled off to leave no scratches. The oxygen concentration of the water used for the in-water post-exposure was measured to be 8 ppm, which was converted to the oxygen concentration of 0.25 mol/m³.

Subsequently, the plate life and the removability of the ink fill-in were evaluated, which were found to be satisfactory as shown in Table 1. Examples 2 to 8

Evaluation was made for the plates subjected to the post-exposure treatment on the basis of the methods in which the low oxygen concentration atmosphere was respectively attained in water in the same manner as in Example 1, and by adhering a film capable of transmitting short wavelength ultraviolet light, by reducing the pressure, and by purging with an inert gas. In each of these methods, the exposure time was controlled by measuring the light intensity substantially irradiated onto the plate by exposure. Further, the oxygen concentrations were measured on the basis of the air pressure measurement in the method based on pressure reduction and on the basis of the control of the mixed content of oxygen in the method based on purging the air with an inert gas.

The plates thus obtained were found to be satisfactory in the plate life and the removability of the ink fill-in as shown in Table 1.

In all the plates after the post-exposure, the tackiness was removed and the plates pressed against a PET film were able to be easily peeled off to leave no scratches on the plates.

### Comparative Examples 1 to 4

In all plates, the tackiness on the plate surface was removed, but the plate surface was worn by a small number of printed sheets; in particular, in Comparative Examples 3 and 4 in each of which the UVC irradiation light quantity was 3000 mJ or more, a large number of cracks were found to occur near the worn portions. The removability of the ink fill-in for the plate in any of Comparative Examples 1 to 4 was found to be poor.

From these experimental results, it has been found that the plate life and the removability of the ink fill-in are remarkably degraded when the post-exposure treatment is applied in an atmosphere in which the partial pressure of oxygen exceeds 9 kPa. It has also been found that the plate life and the removability of the ink fill-in are satisfactory in the low oxygen concentration atmospheres in the in-water treatment and the like.

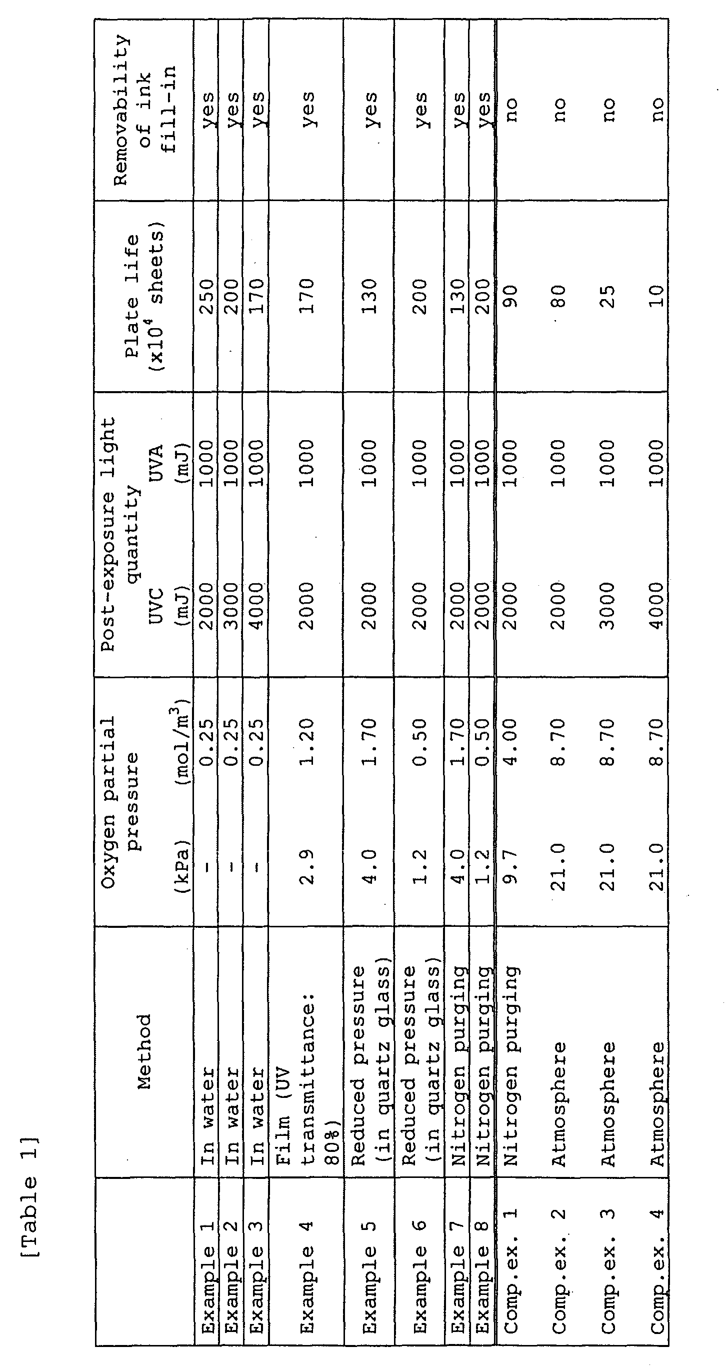

### Examples 9 and 10, and Comparative Examples 5 and 6

The process of the present invention was carried out by use of commercially available, water-developable solid plates 100AQS (trade name, manufactured by Cyrel) and Cosmolight NEO284F (trade name, manufactured by Toyobo Co., Ltd.).

As the liquid developer for 100AQS, there was used an aqueous solution containing D-330 (trade name, manufactured by Cyrel) added in a content of 3 wt% and a developing aid (trade name, manufactured by Cyrel) added in a content of 0.4 wt% respectively.
Development was carried out with the same developing apparatus and at the same developing temperature as in Referential Example 3, the plates were dried at 60°C for 30 minutes, and the post-exposure was carried out on the basis of the methods described in Table 2.

As for NEO284F, development was carried out with the same developing apparatus and at the same developing temperature as in Referential Example 3, the plates were dried at 60°C for 30 minutes, and the post-exposure was carried out on the basis of the methods described in Table 2.

In all the plates after the post-exposure in Examples 9 and 10 and Comparative Examples 5 and 6, the tackiness was removed and a PET film pressed against each of the plate surfaces was able to be easily peeled off to leave no scratches on the plate concerned.

As can be seen from a comparison of Examples 9 and 10 with Comparative Examples 5 and 6, the post-exposure carried out in the low oxygen atmosphere was able to improve the plate life and suppress the ink fill-in on the plate surface.

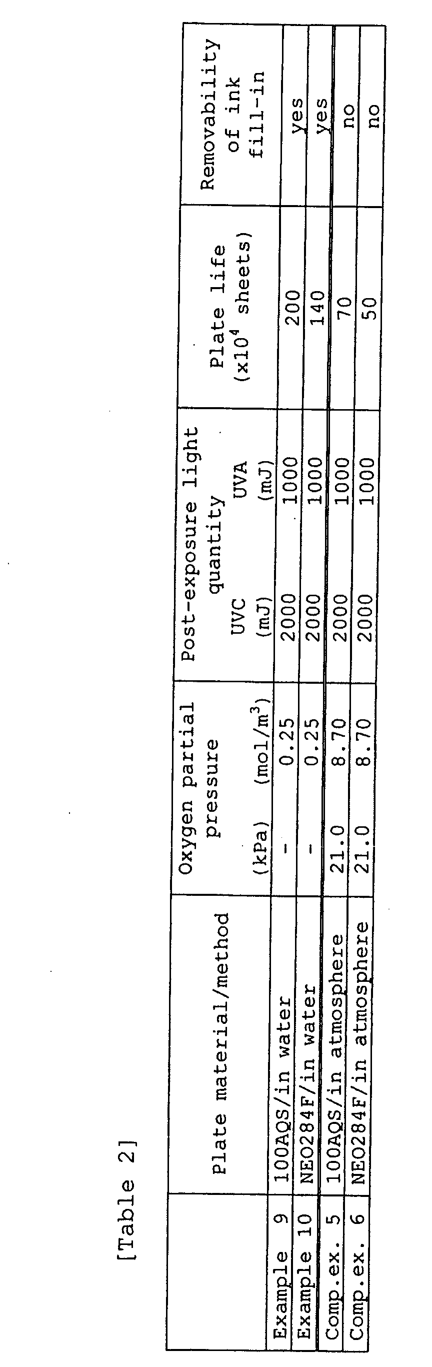

### INDUSTRIAL APPLICABILITY

As described above, by carrying out the exposure treatment in a low oxygen atmosphere in the post-exposure step in the case where a printing plate is prepared from a water-developable solid plate, the plate life and the ink fill-in property of the printing plate thus obtained can be greatly improved. Consequently, the water-developable printing plate of the present invention can be used even under such conditions that conventional water-developable printing plates are seriously worn and hence can not be used, and even on a printing machine for which such conventional printing plates tend to cause ink fill-in easily. Accordingly, an extensive use of the water-developable printing plate which hardly pollutes the environment can be promoted. Because the plate life is not greatly degraded even when the post-exposure light quantity is large, and hence the exposure latitude can be expanded, erroneous operation is made to scarcely occur in the plate-making operation, and thus the water-developable printing plate comes to be further widely used.

## Claims

1. A process for producing a water-developable printing plate for use in relief printing, comprising subjecting a solid plate made of a photosensitive resin composition comprising at least (a) a hydrophilic resin, (b) a hydrophobic resin, (c) a photopolymerizable unsaturated compound and (d) a photopolymerization initiator to at least an exposure step with actinic light, a development step and a post-exposure step, wherein said post-exposure step is carried out in a low oxygen concentration environment.

2. The process according to claim 1, wherein in said post-exposure step, exposure is carried out with ultraviolet light of at least 200 nm to 300 nm wavelength.

3. The process according to claim 1, wherein said low oxygen concentration environment is water.

4. The process according to claim 1, wherein said low oxygen concentration environment is an atmosphere under reduced pressure or an inert gas atmosphere through a film having a transmittance of 5% or more for 250 nm ultraviolet light.

5. The process according to claim 1, wherein said low oxygen concentration environment is an atmosphere under reduced pressure or an inert gas atmosphere.

6. The process according to any one of claims 1 to 5, wherein said hydrophilic resin comprises a conjugated diene as a main component, comprises at least one hydrophilic group selected from the group consisting of a carboxylic acid group, a hydroxy group, a phosphoric acid group and a sulfonic acid group, and has a saturated water content of 1% or more.

7. The process according to any one of claims 1 to 6, wherein said hydrophilic resin comprises fine particles of 5 µm or less in particle diameter with a gel-insoluble fraction of 60% by mass or more, and has a saturated water content of 1% or more.

8. A photosensitive resin printing plate for use in relief printing produced by a process according to any one of claims 1 to 7.
